Europäisches Patentamt

European Patent Office

Office européen des brevets

(11) Publication number: **0 404 049**
**A2**

# (12) EUROPEAN PATENT APPLICATION

(21) Application number: **90111542.8**

(51) Int. Cl.⁵: **C09K 13/02, H01L 21/311**

(22) Date of filing: **19.06.90**

(30) Priority: **20.06.89 JP 155612/89**
**08.12.89 JP 317703/89**

(43) Date of publication of application:
**27.12.90 Bulletin 90/52**

(84) Designated Contracting States:
**DE FR GB**

(71) Applicant: **UBE INDUSTRIES, LTD.**
**12-32, Nishihonmachi 1-chome**
**Ube-shi, Yamaguchi-ken(JP)**

(72) Inventor: **Inoue, Hiroshi, c/o Hirakata Lab.,**
**Ube Ind.,Ltd.**
**3-10, Nakamiya-kita-machi, Hirakata-shi**
**Oosaka(JP)**
Inventor: **Takabayashi, Seiichirou, c/o Ube**
**Chemical Works,**
**Ube Ind.,Ltd., 1978-10, Kogushi, Ube-shi,**
**Yamaguchi-ken(JP)**

(74) Representative: **Kraus, Walter, Dr. et al**
**Patentanwälte Kraus, Weisert & Partner**
**Thomas-Wimmer-Ring 15**
**D-8000 München 22(DE)**

(54) Process for etching polyimide resin.

(57) A process for etching a polyimide resin is disclosed. The polyimide resin to be etched is made of a special aromatic polyimide, which is formed from biphenyltetracarboxylic acid or its derivative and phenylenediamine or its derivative and/or diaminodiphenyl ether or its derivative. The resin is advantageously etched by using a specific etching solution at a temperature in the range of 5 to 100 °C. The etching solution comprises 100 weight parts of hydrazine hydrate and 5 to 120 weight parts of potassium hydroxide.

EP 0 404 049 A2

# PROCESS FOR ETCHING POLYIMIDE RESIN

## FIELD OF THE INVENTION

The present invention relates to a process for etching a special aromatic polyimide resin formed from biphenyltetracarboxylic acid or its derivative. In more detail, the invention relates to a process for etching the special aromatic polyimide resin, which is highly resistant to alkali, by using a specific etching solution under a specific condition.

## BACKGROUND OF THE INVENTION

In general, an aromatic polyimide has been used as an interfacial insulating membrane or a passivation membrane of a multi-layer interconnection board in a transistor, IC or LSI. In such cases a precise etching process is required. Further, the aromatic polyimide film is laminated with copper foil to use the laminate as a flexible print circuit board. In this case it is often necessary to make a hole in the resin by an etching process.

A conventional aromatic polyimide is formed from a pyromellitic acid and an aromatic diamine. The conventional aromatic polyimide has been etched by using various etching solutions. An example of the etching solution is a strong alkaline solution such as an aqueous solution of sodium hydroxide or hydrazine (cf., Japanese Patent Provisional Publications No. 53(1978)-49068, No. 53(1978)-49071, No. 55(1980)-160031 and No. 58(1983)-108230, Japanese Patent Publication No. 61(1986)-4850 corresponding to U.S. Patent Application Ser. No. 327,060 filed on December 3, 1981, and U.S. Patent No. 4,078,096).

On the other hand, another aromatic polyimide is formed from biphenyltetracarboxylic acid or its derivative and an aromatic diamine. This aromatic polyimide is excellent in quality. But, it has been noted that the aromatic polyimide formed from biphenyltetracarboxylic acid or its derivative is difficult to etch by a strong alkaline solution. In more detail, the aromatic polyimide is highly resistant to agents, particularly to alkali compared with the conventional aromatic polyimide formed from a pyromellitic acid and an aromatic diamine (cf., Japanese Patent Provisional Publications No. 56(1981)-118204 and No. 64(1989)-16836).

## SUMMARY OF THE INVENTION

An object of the present invention is to provide a process for etching a special aromatic polyimide resin formed from biphenyltetracarboxylic acid or its derivative. In more detail, the object of the invention is to provide a process for effectively etching the special aromatic polyimide resin, which is highly resistant to alkali, by using an alkaline etching solution.

There is provided by the present invention a process for etching a polyimide resin which is made of an aromatic polyimide formed from biphenyltetracarboxylic acid or its derivative and phenylenediamine or its derivative and/or diaminodiphenyl ether or its derivative,
wherein the resin is etched at a temperature in the range of 5 to 100 °C by using an etching solution which comprises 100 weight parts of hydrazine hydrate and 5 to 120 weight parts of potassium hydroxide.

## DETAILED DESCRIPTION OF THE INVENTION

According to the present invention, the special aromatic polyimide resin is etched at a temperature in the range of 5 to 100 °C, preferably 10 to 90 °C, and more preferably 20 to 80 °C.

In the present invention, the etching rate increases with the rise of temperature. On the other hand, the etching solution tends to boil or decompose if the temperature is extremely high. Thus the temperature is defined as is mentioned above. The optimum temperature is in the range of 40 to 80 °C.

Further, the specific etching solution comprises 100 weight parts of hydrazine hydrate and 5 to 120 weight parts of potassium hydroxide according to the invention. The etching solution preferably comprises 100 weight parts of hydrazine hydrate and 10 to 110 weight parts of potassium hydroxide.

If the amount of potassium hydroxide is extremely small in the etching solution, the etching rate in the solution remarkably decreases, and the industrial productivity of the process is lowered. Further, if the amount of potassium hydroxide is extremely large, the etching solution tends to be heterogeneous because potassium hydroxide precipitates from the etching solution. Therefore, potassium hydroxide should be used in an amount of 5 to 120 weight parts based on 100 weight parts of hydrazine hydrate.

The present inventors have found that potassium hydroxide of the present invention and sodium hydroxide are not equivalent in the function of etching the special polyimide. If potassium hydroxide is replaced by sodium hydroxide, the etching rate remarkably decreases.

In the present invention, the etching solution can contain the other additives, such as an alcohol, a phenol, an alkyl ether and water. As the alcohol or phenol (namely compounds having hydroxyl), a monohydric or dihydric alcohol is preferred. The monohydric or dihydric alcohol preferably is a lower alcohol (containing 1 to 6 carbon atoms), such as methyl alcohol, ethyl alcohol, propyl alcohol and ethylene glycol. The alkyl ether preferably is a lower alkyl ether (the alkyl group contains 1 to 6 carbon atoms), such as dimethyl ether and diethyl ether. In the case that the alcohol, phenol, alkyl ether or water is added to the etching solution, the additive is preferably used in an amount of 5 to 120 weight parts based on 100 weight parts of hydrazine hydrate.

The detailed etching conditions in the process of the invention can be arranged according to the nature, the thickness or the form of the aromatic polyimide to be etched.

The aromatic polyimide used in the process of the present invention is formed from biphenyltetracarboxylic acid or its derivative and phenylenediamine or its derivative and/or diaminodiphenyl ether or its derivative.

In preparation of the special aromatic polyimide, the biphenyltetracarboxylic acid or its derivative is used as an aromatic tetracarboxylic acid ingredient. The aromatic tetracarboxylic acid ingredient preferably contains the biphenyltetracarboxylic acid or its derivative as the main component (preferably in an amount of not less than 60 mole %, and more preferably not less than 70 mole %). Examples of the biphenyltetracarboxylic acid or its derivative include 3,3',4,4' biphenyltetracarboxylic acid, anhydride thereof, 2,3,3',4'-biphenyltetracarboxylic acid and anhydride thereof.

In preparation of the aromatic polyimide, the phenylenediamine or its derivative and/or the diaminodiphenyl ether or its derivative are used as an aromatic diamine ingredient. The aromatic diamine ingredient prefer ably contains the phenylenediamine or its derivative and/or the diaminodiphenyl ether or its derivative as the main component (preferably in an amount of not less than 80 mole %). Examples of the phenylenediamine or its derivative in. clude o-, m- or p-phenylenediamine. Examples of the diaminodiphenyl ether or its derivative include 4,4'-diaminodiphenyl ether, 3,4'-diaminodiphenyl ether and 3,3'-diaminodiphenyl ether.

In the present invention, the biphenyltetracarboxylic acid or its derivative preferably is 3,3',4,4'-biphenyltetracarboxylic acid or its derivative. The phenylenediamine or its derivative preferably is p-phenylenediamine or its derivative. The diaminodiphenyl ether or its derivative preferably is 4,4'-diaminodiphenyl ether or its derivative. Accordingly, it is particularly preferred that the aromatic polyimide is formed by polymerizing and imidizing an aromatic tetracarboxylic acid ingredient mainly containing 3,3',4,4',-biphenyltetracarboxylic acid or its derivative and an aromatic diamine ingredient mainly containing p-phenylenediamine or its derivative and 4,4'-diaminodiphenyl ether or its derivative.

The above-mentioned aromatic tetracarboxylic acid ingredient can contain pyromellitic acid, benzophenonetetracarboxylic acid, diphenyl ethertetracarboxylic acid and their derivatives in addition to the biphenyltetracarboxylic acid or its derivative.


EXAMPLE 1


Preparation of polyimide film


Equimolecular amounts of 3,3',4,4'-biphenyltetracarboxylic dianhydride and p-phenylenediamine were polymerized for 4 hours at 30 °C in N,N-dimethylacetamide (solvent) to obtain a solution of an aromatic polyamic acid. The solution was spread on a glass plate to form a thin membrane having a uniform thickness, and heated at 120 °C for 10 minutes to obtain a self-supporting film. The film was heated at 200 °C for 10 minutes, then at 300 °C for 10 minutes, and further at 440 °C for 5 minutes to remove the solvent and to imidize the polymer. Thus an aromatic polyimide film containing substantially no solvent and having thickness of 75 μm was prepared.

Preparation of etching solution

An etching solution was prepared by mixing 100 weight parts of hydrazine hydrate and 112 weight parts of potassium hydroxide.

Etching test

The above-prepared aromatic polyimide film was immersed in the etching solution. The film in the solution was left at room temperature (at about 25 °C) for 50 minutes to etch the film. Then, the etching rate was measured.

The measured etching rate in terms of the thickness of the film decreased per 50 minutes is set forth in Table 1.

EXAMPLES 2-5 and COMPARISON EXAMPLE 1

The film was etched and the etching rate was measured in the same manner as in Example 1, except that the composition of the etching solution was changed as is set forth in Table 1.

The results are also set forth in Table 1.

EXAMPLES 6 and 7

The film was etched and the etching rate was measured in the same manner as in Example 1, except that the etching solution comprised hydrazine hydrate, potassium hydroxide and ethanol as is set forth in Table 1.

The results are also set forth in Table 1.

COMPARISON EXAMPLES 2-8

The film was etched and the etching rate was measured in the same manner as in Example 1, except that the composition (the ingredients and the amounts thereof) of the etching solution was changed as is set forth in Table 1.

The results are also set forth in Table 1.

EXAMPLE 8

Preparation of polyimide film

An aromatic polyimide film was prepared in the same manner as in Example 1, except that 4,4'-diaminodiphenyl ether was used in place of p-phenylenediamine.

Etching test

The above-prepared aromatic polyimide film was immersed in the etching solution set forth in Table 1.

4

The film in the solution was left at room temperature (at about 25 °C) for 50 minutes to etch the film. Then, the etching rate was measured.

The measured etching rate in terms of the thickness of the film decreased per 50 minutes is set forth in Table 1.

## EXAMPLE 9

### Preparation of polyimide film

An aromatic polyimide film was prepared in the same manner as in Example 1, except that 2,3,3′,4′-biphenyltetracarboxylic dianhydride was used in place of 3,3′,4,4′-biphenyltetracarboxylic dianhydride.

### Etching test

The above-prepared aromatic polyimide film was immersed in the etching solution set forth in Table 1. The film in the solution was left at room temperature (at about 25 °C) for 50 minutes to etch the film. Then, the etching rate was measured.

The measured etching rate in terms of the thickness of the film decreased per 50 minutes is set forth in Table 1.

## EXAMPLE 10

### Preparation of polyimide film

An aromatic polyimide film was prepared in the same manner as in Example 1, except that 3,3′,4,4′,-biphenyltetracarboxylic dianhydride (0.5 mole) and pyromellitic acid (0.5 mole) were used as the aromatic tetracarboxylic acid ingredient, and p-phenylenediamine (0.7 mole) and 4,4′-diaminodiphenyl ether (0.3 mole) were used as the aromatic diamine ingredient.

### Etching test

The above-prepared aromatic polyimide film was immersed in the etching solution set forth in Table 1. The film in the solution was left at room temperature (at about 25 °C) for 50 minutes to etch the film. Then, the etching rate was measured.

The measured etching rate in terms of the thickness of the film decreased per 50 minutes is set forth in Table 1.

## EXAMPLES 11-14

### Preparation of polyimide film

An aromatic polyimide film was prepared in the same manner as in Example 1, except that the thickness of the film was changed from 75 μm to 25 μm.

### Preparation of etching solution

An etching solution was prepared by mixing 100 weight parts of hydrazine hydrate and 43 weight parts of potassium hydroxide.

Etching test

The above-prepared aromatic polyimide film having thickness of 25 $\mu$m was immersed in the etching solution. The film in the solution was left at 25 °C, 40 °C, 60 °C or 70 °C to completely dissolve the film in the etching solution. Thus the etching rate (the time required for dissolving the film) was measured.
The measured etching rates (seconds) are set forth in Table 2.

TABLE 1

| | Composition of Etching Solution* | | | | | |
| --- | --- | --- | --- | --- | --- | --- |
| | Hydrazine Hydrate | Hydroxide | | Another Additive | | Etching Rate** Thickness |
| | | Kind | Amount | Kind | Amount | |
| Ex. 1 | 100 | KOH | 112 | --- | --- | 23 |
| Ex. 2 | 100 | KOH | 56 | --- | --- | 52 |
| Ex. 3 | 100 | KOH | 18.7 | --- | --- | ≧ 75 |
| Ex. 4 | 100 | KOH | 10.7 | --- | --- | 47 |
| Ex. 5 | 100 | KOH | 7.1 | --- | --- | 32 |
| Ex. 6 | 100 | KOH | 112 | Ethanol | 50 | 23 |
| Ex. 7 | 100 | KOH | 56 | Ethanol | 100 | 24 |
| Ex. 8 | 100 | KOH | 18.7 | --- | --- | ≧ 75 |
| Ex. 9 | 100 | KOH | 18.7 | --- | --- | ≧ 75 |
| Ex. 10 | 100 | KOH | 18.7 | --- | --- | ≧ 75 |
| Com. 1 | 100 | KOH | 3.5 | --- | --- | 15 |
| Com. 2 | 100 | NaOH | 80 | --- | --- | 13 |
| Com. 3 | 100 | NaOH | 40 | --- | --- | 10 |
| Com. 4 | --- | KOH | 56 | $CH_3NHNH_2$ | 46 | 0 |
| Com. 5 | 100 | --- | --- | --- | --- | 0 |
| Com. 6 | --- | NaOH | 10 | Water | 90 | 0 |
| Com. 7 | 100 | --- | --- | $C_2H_4(NH_2)_2$ | 100 | 0 |
| Com. 8 | 100 | --- | --- | NMP*** | 25 | 0 |
| Remark: | | | | | | |

Etching Solution*: Composition represented by weight parts
Etching Rate**: Etched thickness ($\mu$m) at 25 °C for 50 minutes
NMP***: N-methylpyrrolidone

TABLE 2

| | Etching Temperature (°C) | Etching Solution* | | | |
|---|---|---|---|---|---|
| | | Hydrazine Hydrate | Hydroxide | | Etching Rate** Time |
| | | | Kind | Amount | |
| Example 11 | 25 | 100 | KOH | 43.0 | 360 |
| Example 12 | 40 | 100 | KOH | 43.0 | 300 |
| Example 13 | 60 | 100 | KOH | 43.0 | 60 |
| Example 14 | 70 | 100 | KOH | 43.0 | 30 |
| Remark: | | | | | |

Etching Solution*: Composition represented by weight parts
Etching Rate**: Time (seconds) required for dissolving a film (thickness: 25μm)

EFFECT OF THE INVENTION

According to the etching process of the present invention, the special aromatic polyimide resin formed from biphenyltetracarboxylic acid or its derivative, which is highly resistant to alkali, can be effectively and rapidly etched by using an etching solution which comprises hydrazine hydrate and potassium hydroxide in a specific ratio. Therefore, an aromatic polyimide used as an interfacial insulating membrane of a multi-layer interconnection board in a transistor, IC or LSI can be easily etched by the process of the present invention.

**Claims**

1. A process for etching a polyimide resin which is made of an aromatic polyimide formed from biphenyltetracarboxylic acid or its derivative and phenylenediamine or its derivative and/or diaminodiphenyl ether or its derivative,
wherein the resin is etched at a temperature in the range of 5 to 100 °C by using an etching solution which comprises 100 weight parts of hydrazine hydrate and 5 to 120 weight parts of potassium hydroxide.

2. The process as claimed in claim 1, wherein the resin is etched at a temperature in the range of 10 to 90 °C.

3. The process as claimed in claim 1, wherein the resin is etched at a temperature in the range of 20 to 80 °C.

4. The process as claimed in claim 1, wherein the etching solution comprises 100 weight parts of hydrazine hydrate and 10 to 110 weight parts of potassium hydroxide.

5. The process as claimed in claim 1, wherein the etching solution comprises 100 weight parts of hydrazine hydrate, 5 to 120 weight parts of potassium hydroxide and 10 to 100 weight parts of an alcohol, a phenol, an alkyl ether or water.

6. The process as claimed in claim 1, wherein the biphenyltetracarboxylic acid or its derivative is 3,3′,4,4′-biphenyltetracarboxylic acid or its derivative.

7. The process as claimed in claim 1, wherein the phenylenediamine or its derivative is p-phenylenediamine or its derivative.

8. The process as claimed in claim 1, wherein the diaminodiphenyl ether or its derivative is 4,4′-diaminodiphenyl ether or its derivative.